Europäisches Patentamt

European Patent Office

Office européen des brevets

(11) Publication number: **0 193 172 B1**

# EUROPEAN PATENT SPECIFICATION

(45) Date of publication of patent specification: **29.07.92**  (51) Int. Cl.⁵: **H01L 27/08**

(21) Application number: **86102456.0**

(22) Date of filing: **25.02.86**

(54) **Vertical MOS transistor with peripheral circuit.**

(30) Priority: **26.02.85 JP 35224/85**

(43) Date of publication of application:
**03.09.86 Bulletin 86/36**

(45) Publication of the grant of the patent:
**29.07.92 Bulletin 92/31**

(84) Designated Contracting States:
**DE FR GB**

(56) References cited:
**EP-A- 0 118 921**
**DE-A- 2 456 635**
**GB-A- 1 443 999**

**IEEE ELECTRON DEVICE LETTERS, vol. EDL4, no. 6, June 1986, pages 196-198, New York, US; W. YEH et al.: "A new CMOS structure with vertical p-channel transistors"**

(73) Proprietor: **NISSAN MOTOR CO., LTD.**
**2 Takara-cho, Kanagawa-ku**
**Yokohama-shi Kanagawa-ken 221(JP)**

(72) Inventor: **Matsushita, Tsutomu**
**24-19, Nagatadai Minami-ku**
**Yokohama-shi Kanagawa-ken(JP)**
Inventor: **Murakami, Koichi**
**5-13-10, Iwato**
**Yokosuka-shi Kanagawa-ken(JP)**

(74) Representative: **Patentanwälte Grünecker, Kinkeldey, Stockmair & Partner**
**Maximilianstrasse 58**
**W-8000 München 22(DE)**

EP 0 193 172 B1

## Description

BACKGROUND OF THE INVENTION

(1) Field of the Invention

The present invention relates to a semiconductor device in which a vertical type MOS transistor and a MOS circuit for controlling the transistor are formed on a same semiconductor substrate.

(2) Description of the Prior Art

Power MOS transistors are widely being used as switching elements for different power loads, since its appearance, especially the demand for the vertical type MOS transistors having a low on resistance have been increasing.

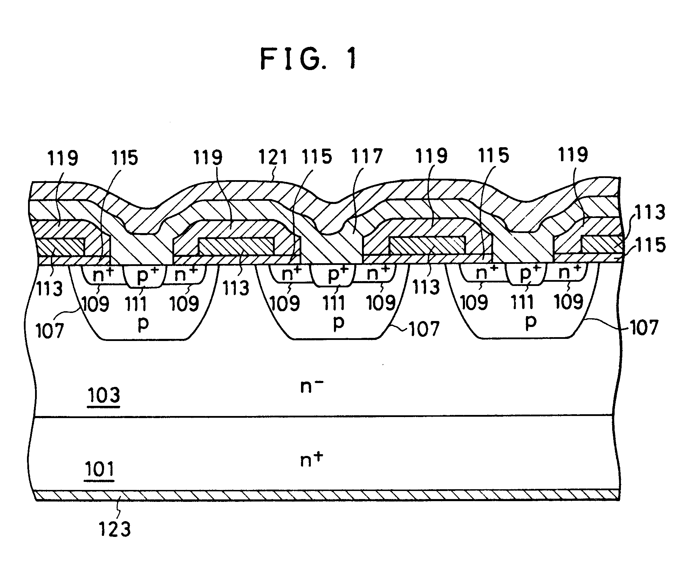

Fig. 1 shows one example of the vertical type MOS transistor device which is known, for example, from document EP-A-0 118 921. In the figure, the MOS transistor device comprises a $n^+$ type semiconductor substrate 101 and $n^-$ type semiconductor region 103 formed on the substrate by an epitaxial growth which constitutes a drain region.

The MOS transistor also comprises a plurality of p type well regions 107 in the $n^-$ type region 103, a pair of $n^+$ type source regions 109 in the well region 107 and a $p^+$ type well contact region 111 sandwiched by the source region 109, each formed by impurity diffusion. The $n^+$ type substrate 101, the $n^-$ type region 103, the p type regions 107, each group of the $n^+$ type source regions 109 and the $p^+$ type well contact region 111 formed in each of the p type regions are configured to carry out a desired operation as a vertical MOS.

On the semiconductor, there is formed each gate oxide film 115 i.e., on the surfaces of the pair of the $n^+$ type source regions 109 and each of the p type well regions 107 centered around the extended portion of the $n^-$ type drain region 103. On the gate oxide film 115, there is provided gate elecrodes 113 made of polysilicon, intermediate insulating layers 119 which rap the gate electrodes 113 respectively, a source electrode 117 formed on the insulating layers 119 and contacting the remaining surface of the semiconductor layer to be in contact with the contact regions 111 and the source regions 109, and a final protection film or layer 121 formed thereon. The gate electrodes 113 are used as makes and the p type, $n^+$ type and $p^+$ type regions are all formed successively by impurity diffusion.

In this vertical type MOS transistor according to the prior art, when a drain voltage $V_d$ is applied to the bottom side of the substrate 101 through an electrode 123 and the $n^+$ type source region 109 is connected to the ground through a power load not indicated, the current flowing through the substrate 101, the n type region 103, and the $n^+$ source region 109 is on/off controlled by the control of the voltage applied to the gate electrodes 113, thus enabling the power load to be drivably controlled.

In the vertical type MOS transistor, however, its switching function must be carried out by the control of the voltage applied to tee gate electrodes 113 as described above. For practical use of the device, different peripheral circuits including the one for the power supply must be connected to the transistor chip, although not shown in the drawing. The provision of the peripheral circuits on a same substrate of the vertical type MOS transistor produces, to be sure, some merits such as minituarization of the circuits, reduction in working processes, prevention of malfunction due to dispersions among the characteristics of parts, as compared with the case where the peripheral circuits are externally connected to the MOS transistor chip.

For these reasons, it is conceivable that the vertical type MOS transistors and the peripheral circuits thereof may be formed on the same substrate of the MOS transistor. In that case, the substrate 101 and the $n^-$ region or layer constitute a drain as a path for current, the peripheral circuit or circuits must be electrically isolated from the substrate 101 and the $n^-$ type region 103. For this end, there has heretofore been proposed a method for forming the peripheral circuit wherein a p type region is firstly formed in part of the $n^-$ type region 103, then the p type region is ground and the peripheral circuit is formed therein (see, for instance, Japanese Patent Published Application No. 58-164323).

In order to constitute the peripheral circuit by use of a MOS circuit according to the prior art, however, a complicated manufacturing process is required, such as forming the p type region in the $n^-$ type region 103 by diffusion technique, then forming the $n^+$ type region in the p type region, and finally forming n-channel and p-channel MOS transistors respectively in the p type and n type regions. As a result, the following problem occurs.

Namely, in order to reduce the ON-resistance of the vertical type MOS transistor, the n type region 103 has to have a somewhat high impurity concentration. In addition, each p type region to be formed in the n type region 103 for the peripheral circuit must also have a relatively high impurity concentration and the $n^+$ type regions formed by inpurity diffusion in each of the p type regions must also have a higher impurity concentration in a progressive manner in either p-channel or n-channel type MOS transistor. Consequently, the threshold voltage $V_T$ of the MOS transistor tends essentially to be high and it is no longer suitable as a peripheral circuit.

## SUMMARY OF THE INVENTION

It is an object of the present invention, therefore, to overcome the above drawbacks and to provide an improved semiconductor device having a vertical type MOS transistor and a MOS circuit as peripheral circuit both formed on the same substrate having a low threshold value.

It is another object of the present invention to provide an improved semiconductor device wherein a buried layer having a high impurity concentration is provided at a C-MOS so as to prevent a latchup phenomena from occuring.

It is still another object of the present invention to provide an improved semiconductor device in which a vertical type MOS transistor having a low on-resistance with a smaller surface area than that of the prior art can be realized, with the same performance maintained.

It is still further object of the present invention to provide an improved semiconductor device having a zener diode portion having a large capacity together with a MOS transistor portion.

The afore-mentioned objects of the present invention can be attained by a semiconductor device comprising the features described in independent claim 1.

## BRIEF DESCRIPTION OF THE DRAWINGS

Fig. 1 is a cross-sectional view of the vertical type MOS transistor chip according to the prior art,
Fig. 2 is a cross-sectional view of one embodiment of the semiconductor device according to the present invention,
Fig. 3 is a cross-sectional view of a C-MOS circuit portion with no buried layer,
Fig. 4 is a cross-sectional view of the C-MOS circuit portion with the buried layer having a high impurity concentration for explaining the fuction of the semiconductor device of Fig. 2 according to the present invention in comparison with that shown in Fig. 3,
Figs. 5(A) through 5(K) is a process of manufacturing the semiconductor device of Fig. 2, according to the present invention,
Fig. 6 is a cross-sectional view of a second embodiment of the semiconductor device according to the present invention, and
Fig. 7 is a cross-sectional view of a third embodiment of the semiconductor device according to the present invention.

## DESCRIPTION OF THE PREFERRED EMBODIMENT

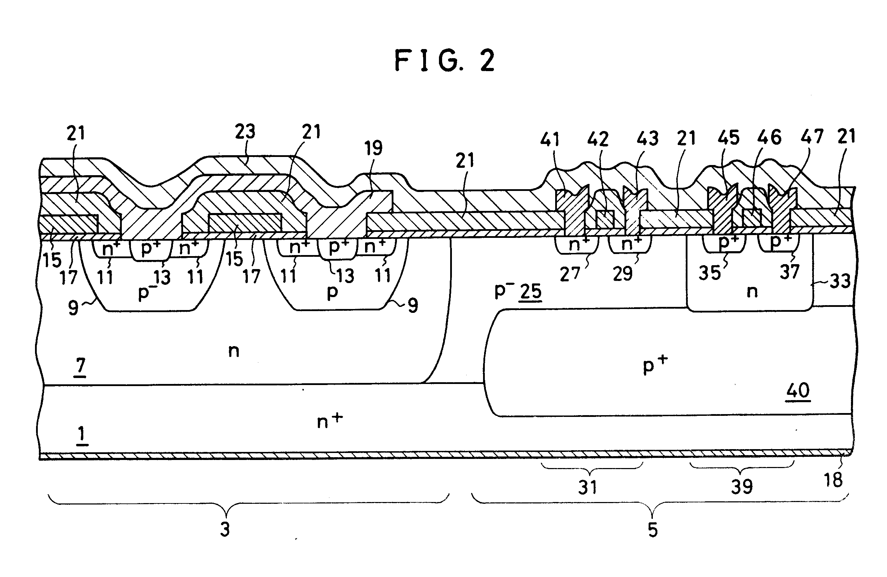

Fig. 2 shows a cross-sectional view of the semiconductor device having mainly a vertical type MOS transistor 3 and a C-MOS circuit 5 both formed on a $n^+$ type semiconductor substrate 1.

The structure of the vertical type MOS transistor portion 3 in Fig. 2 is same as that shown in Fig. 1. Namely, the MOS transistor portion 3 comprises a $n^+$ type substrate 1, a $n^-$ type drain region 7 formed thereon, a p type well regions 9 diffused in the drain region 7, and $n^+$ source regions 11 and $p^+$ well contact region 13 diffused in the p type regions which constitute a semiconductor layer. The n type region continuously extends in the upper direction until it forms the same surface together with the $n^+$ type, $p^+$ type regions and each part of the type p regions. A gate oxide film 17 is formed on the upper semiconductor layer bridging the adjacent $n^+$ type source regions centered around the extended part of the n type region and each gate electrode 15 is formed thereon. On the bottom of the substrate 1 is formed a drain electrode 18.

The gate electrode 15 is covered with an intermediate insulating film 21. A source electrode 19 is formed on each of the insulating films and it also contacts the $n^+$ and $p^+$ type regions respectively. Reference numeral 23 indicates a final protection film or layer.

On the other hand, the C-MOS circuit 5 consisting of an n channel MOS transistor 31 and a p channel MOS transistor 39, which comprises the same $n^+$ type substrate 1 which is shared with the MOS transistor 3, a $p^-$ type layer 25 which is an epitaxial layer on the substrate 1, a $p^+$ buried layer 40 formed between the $p^-$ type layer 25 and the $n^+$ type substrate 1, a n type layer 33 diffused in the $p^-$ type layer 25. A pair of the $n^+$ type regions 27 and 29 diffused in the $p^-$ type layer 25 as drain and source (n channel MOS drain and n channel MOS source), and a pair of the $p^+$ type regions 35 and 37 (p channel MOS drain and p channel MOS source) diffused in the n type layer 33. Reference numerals 41 and 43 indicate n channel MOS source and drain electrodes which are connected to the $n^+$ type regions and numeral 42 indicates a gate electrode for the n channel MOS transistor 31 while numeral 45 and 47 indicate p channel MOS drain and source electrodes which connected to the $p^+$ type regions 35 and 37. Numeral 46 indicates a gate electrode for the p channel MOS transistor 39.

In the semiconductor device having the structure described above, according to the present invention, when the $p^-$ type epitaxial layer 25 and the buried $p^+$ type layer 40 are grounded, the vertical type MOS transistor 3 is electrically isolated from the C-MOS circuit 5 which constitutes a peripheral circuit for the vertical transistor 3, as it is reversely biased with the PN junction between the n type well region 7 and the p⁻ type epitaxial layer 25.

In addition, as the C-MOS circuit 5 is formed in the p⁻ type layer 25 having a low impurity concentration, the impurity concentration of the n well region 33 formed therein can also be maintained low. Consequently, the C-MOS circuit constructed on the same substrate as that of the vertical type MOS transistor and having same characteristics as those constructed with a monolith can be realized.

On the other hand, particular effects which will be described later can be produced by the provision of the buried P⁺ layer 40.

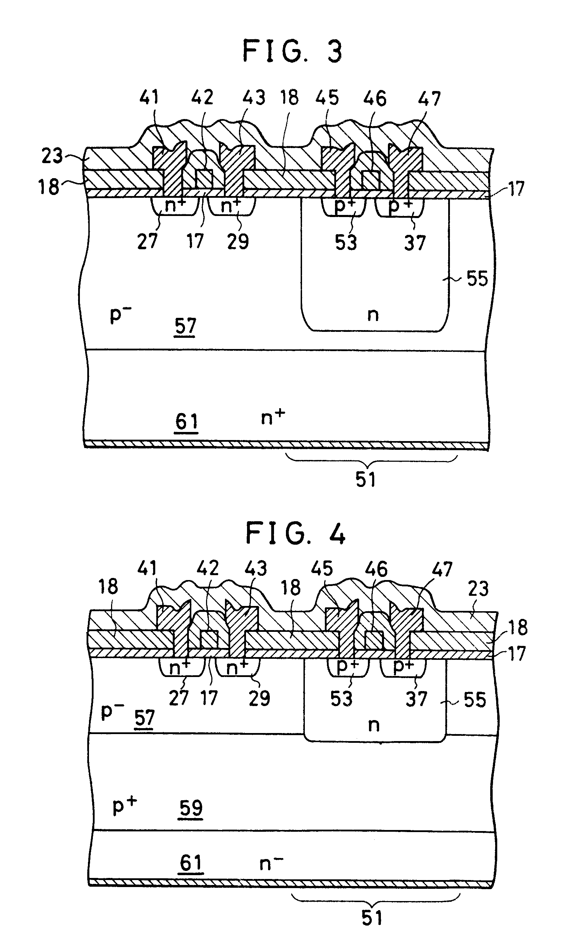

Fig. 3 shows the C-MOS circuit configuration 51 having no buried p⁺ layer while Fig. 4 shows the C-MOS circuit configuration having the buried p⁺ layer 59, for comparison of their functions. In both circuits, there is formed a parasitic PNPN junction due to the p⁺ drain regions 53, 37, the n well region 55, either the p⁻ epitaxial layer 57 (Fig. 3) or p⁺ buried layer 59 (Pig. 4) and n⁺ substrate 61.

In the C-MOS circuit 51 without the buried layer 59 shown in Fig. 3, since the thickness of the epitaxial layer 57 is determined by the specification of the vertical MOS its thickness cannot be too much increased. As a result, the distance between the n well region 55 and the substrate 61 necessarily tends to be narrow while as the impurity concentration of the p⁻ layer 57 is normally low so that so-called "latch-up" phenomena often tends to occur, which causes the PNPN junction to render conductive.

On the other hand, in the C-MOS circuit 51 with the buried layer 59 shown in Fig. 4, the distance between the n well region 55 and the substrate 61 is sufficiently procured by the thickness of the p⁺ buried layer 59 while the impurity concentration of the p⁺ buried layer 59 is maintained rather high. As a result, the latch-up phenomena described above is difficult to occur. The construction of the remaining portions of the C-MOS circuit 51 in Fig. 4 is same that in Fig. 3 so that no additional description will be necessary. Same reference nemerals are attached to the corresponding elements in Figs. 3 and 4.

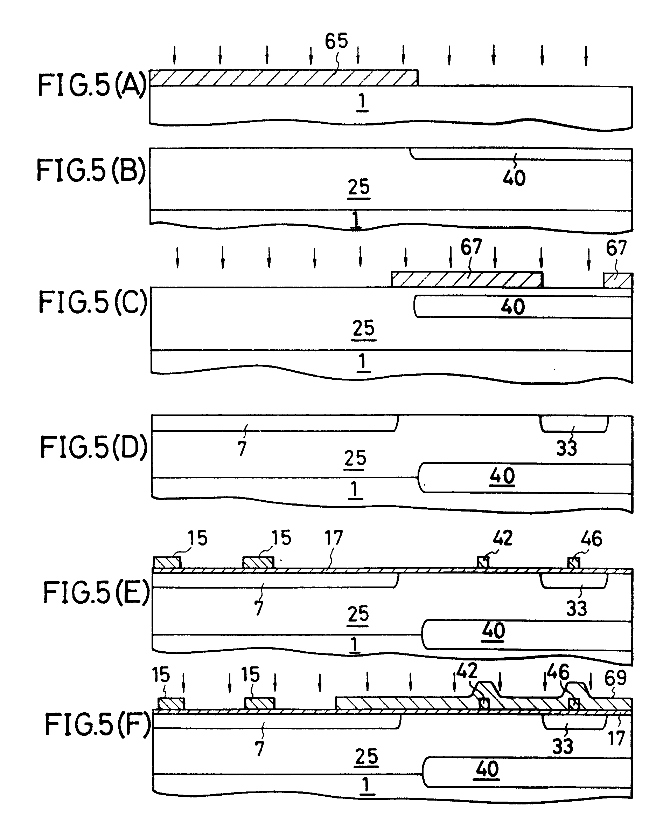

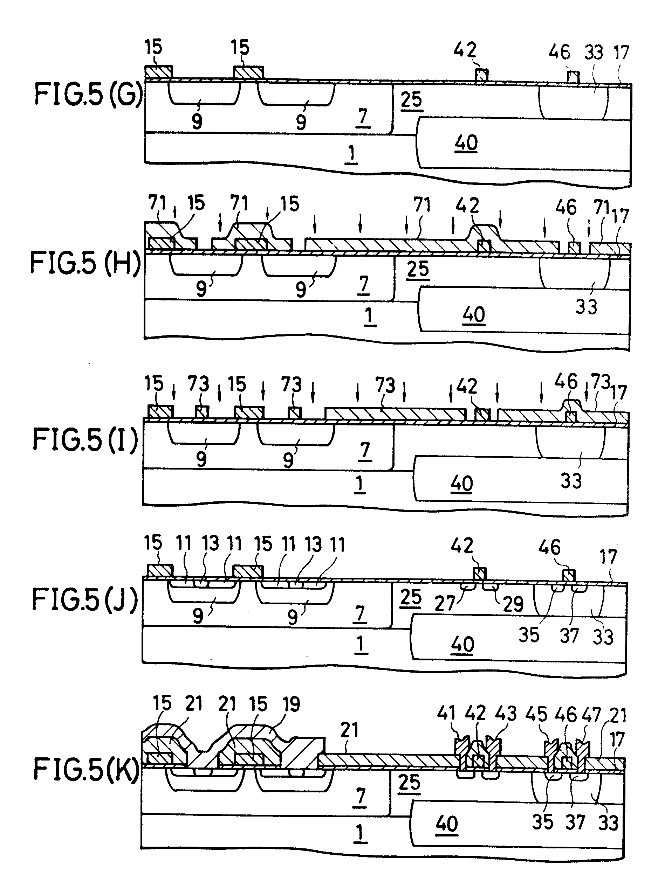

Figs. 5(A) through (K) show a process for manufacturing the vertical type MOS transistor device of one embodiment according to the present invention.

(i) In order to form the p⁺ buried layer 40 on the same substrate 1 of the vertical type MOS transistor 3, a resist 65 is first formed on the upper surface of the substrate 1 and then boron is implanted only on the region of the substrate 1 to be a C-MOS circuit 5. After this process, the resist 65 is removed (see Fig. 5(A)).

(ii) Next, the p⁻ epitaxial layer 25 is grown on the substrate 1 (see Fig. 5(B)).

(iii) In order to form the n well region for a vertical MOS and the n well region for the C-MOS on the p⁻ epitaxial layer 25, resists 67 are firstly formed at a predetermined positions and then the phosphorus (P) is implanted. After this process, the resists 67 are removed (see Fig. 5-(C)).

(vi) A first diffusion operation is carried out and the buried layer 40, the n well region 7, and the n well region 33 for the C-MOS are formed (see Fig. 5(D)).

(v) On the p⁻ epitaxial layer 25 thus diffusion-processed, there is formed a gate oxide film 17 and then polysilicon gates 15, 42, 46 are formed at predetermined positions on the oxide film 17 thus formed, as gate electrodes (see Fig. 5(E)).

(iv) In order to form the p well regions within the n well region 7, a resist 69 is first formed over a predetermined range on the oxide film 17, and then boron is implanted thereon. After this process, the resist 69 is removed (see Fig. 5(F)).

(vii) A second diffusion processing is carried out, so as to form the p well regions 9. At this time, the n well region 7 extends until it reaches the substrate 1 while the n well region 33 and the buried layer 40 extend respectively until they contact each other (see Fig. 5(G)).

(viii) A plurality of resists 71 are first formed on the semiconductor layer thus formed except for the portions where the p well contact regions 13 and the source and dram regions 35, 37 of the p channel MOS transistor 39 to be formed and then the boron is implanted thereon. After this processing, the resists 71 are removed (see Fig. 5(H)).

(ix) A plurality of resists 73 are firstly formed except for the portions to be the n⁺ source regions 11 for the vertical MOS, the drain region and the source region for the n channel MOS transistor 31, and then phosphorus is implanted thereto. After this processing, the resists 73 are removed (see Fig. 5(I)).

(x) A third diffusion processing is performed and the n⁺ source regions 11, the p⁺ well contact region 13, the drain region 27, the source region 29, the p⁺ drain region 35, and the p⁺ source region 37 are formed (see Fig. 5(J)).

(xi) The intermediate insulating films 21 are deposited by a CVD method and selectively removed by a photo-etching to form openings at positions where electrodes are to be provided, then alminum vapor deposition is carried out to prepare a source electrode 19 for the vertical MOS, a source electrode 47 and a drain electrode 45 for the p channel MOS, a drain electrode and a source electrode 43 for the n channel MOS transistor by removing the aluminum layer by the photo-etching processing except for the electrode portions to be formed (see Fig. 5-(K)).

(xii) The final protection film 23 is deposited by a CVD method on the whole surface of the semiconductor device and perforations are carried at ereas for preparing contacts by a photo-etching method, thus completing the semiconductor device.

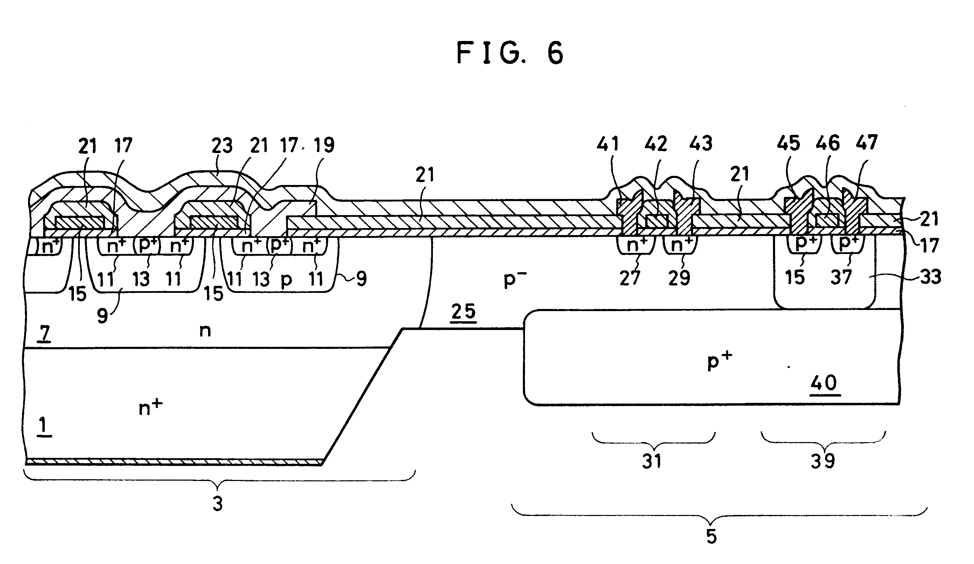

Fig. 6 shows another embodiment of the semiconductor device according to the present invention. The same reference numerals used in Fig. 2 are attached to the corresponding portions in this embodiment. The difference between this semiconductor device and that shown in Fig. 2 is that the part of the substrate 1 for the C-MOS circuit 5, each part of the $p^-$ epitaxial layer 25 5, the n well region 7 and the substrate 1 for the vertical type MOS transistor 3 are removed in such a manner that are eliminated only sections which can be dispensed with as shown in Fig. 6.

With this construction, the PNPN junction no longer exists in the p channel MOS 39 in the C-MOS circuit 5, unlike the one shown in Fig. 2 so that the latch-up phenomena can be completely excluded together with the existence of the buried layer 40.

Furthermore, since the C-MOS circuit 5 is completely separated from the vertical type MOS transistor 3 by the PN junction lied between the n well region 7 and the $p^-$ epitaxial layer 25, the impurity concentration of the $p^-$ epitaxial layer 25 can be freely determined irrespective of the characteristics of the vertical MOS transistor 3. As a result, flexibility of the design for the C-MOS circuit 5 can be increased.

The removal of the portions in Fig. 5 can be carried out by the etching method after the final processing has been finished as shown in Fig. 5-(K).

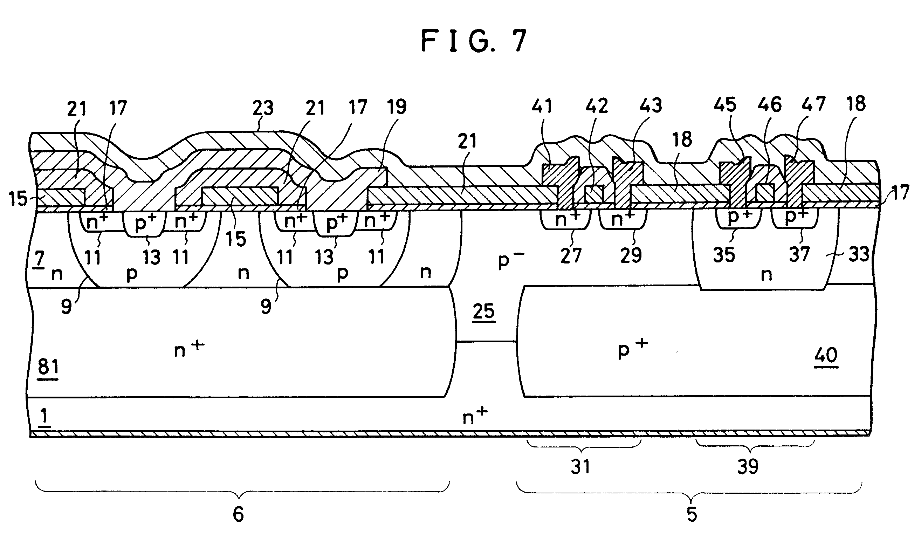

Fig. 7 shows a third embodiment of the semiconductor device according to the present invention. Here again the same reference numerals are attached to the same elements in the embodiment in Fig. 2.

In this embodiment, between the substrate 1 of the vertical MOS transistor 3 and the n well region 7, there is provided a PN junction by the $n^+$ type buried layer 81 and the p well region 9. With this construction, a zener diode having a large capacity is formed in the vertical type MOS transistor 3 among the substrate 1 constituting a drain region, the $n^+$ buried layer 81, the n well region 7 and the $n^+$ source region 11. As a result, the following effects can be produced;

(i) By using the semiconductor device according to the present invention, for the purpose of switching an inductive load, it is not necessary for the vertical type MOS transistor itself to increase the durability to high voltage as a surge current flows through the zener diode formed within the semiconductor device, which is produced at the time of switching.

(ii) Since there is no necessity of increasing the durability to high voltage, contrary to the semiconductor device according to the prior art, a vertical type MOS transistor having a lower ON resistance with a less surface area than that of the prior art can be realized, with same performance.

The process for manufacturing the semiconductor device of the third embodiment according to the present invention is as follows:

In the step (i) in Fig. 5, where after the boron is implanted as shown in Fig. 5(A), a resist is formed on the upper surface of the substrate 1 both the vertical type MOS transistor 3 and for the C-MOS circuit 5 and then phosphorus is implanted thereon so as to form the $n^+$ type buried layer 81. The same manufacturing process shown in Fig. 4 is applied afterwards.

Namely, the vertical type MOS transistor 3 is formed as shown in Fig. 7 by forming the n well region 7 and the $n^+$ type buried layer 81. As a result, the C-MOS circuit 5 is never influenced by the transistor 3, especially by the existence of the n well region 7 and the $n^+$ buried layer 81 while the C-MOS circuit 5 can be constructed within the $p^-$ epitaxial layer 25 with a low impurity concentration, in a good condition.

In the foregoing three embodiments according to te present invention, the description has been made about the n channel channel vertical type MOS transistor. However, it is apparent that p channel channel vertical type MOS transistor may be used for the embodiments as well.

Moreover, the description has also been made about the C-MOS circuit consisting of the n channel MOS and p channel MOS semiconductor. However, it is also possible that the MOS circuit may be made by a monolith of n channel MOS and p channel MOS regions.

As has been described in the foregoing, the semiconductor device according to the present invention comprises a vertical type MOS transistor formed on a first type substrate and having at least one PN junction among said semiconductor layers and a C-MOS circuit including a second type buried layer having a high impurity concentration formed on the same substrate of said vertical type MOS transistor portion, the conduction level of the PN junction of the MOS transistor being lower than that of said buried layer bordering other semiconductor layers in the C-MOS circuit portion, thereby preventing so-called latch-up phenomena from occuring while enabling the COMOS circuit to be formed on the same substrate of the vertical type MOS transistor in a desired condition.

## Claims

1. A semiconductor device comprising:

   a substrate (1) of a first conductivity type;

   an epitaxial layer (25) of a second conductivity type opposite to the first conductivity type;

   a drain diffused region (7) of the first conductivity type extending from the surface of the epitaxial layer (25) to a depth at which it is in contact with the substrate (1);

   a channel region (9) of the second conductivity type formed in the upper portion of said drain diffused region (7) and forming a first well region;

   source regions (11) of the first conductivity type formed within said channel region (9);

   a gate electrode (15) formed on the channel region (9) via a gate oxide film (17) formed therebetween;

   a source electrode (19) in contact with the source regions (11);

   a drain electrode (18) in contact with the substrate (1);

   said three regions, three electrodes and substrate constituting a vertical MOS transistor (3) jointly; and

   a circuit (5) fabricated on the epitaxial layer (25) which is electrically isolated from the vertical MOS transistor (3) during operation by a reverse bias between the substrate (1) and the epitaxial layer (25).

2. The device of claim 1, wherein the circuit (5) comprises a CMOS device including a buried region (40) of the second conductivity type, formed between the epitaxial layer (25) and the substrate (1), the buried region (40) having a higher impurity concentration than that of the epitaxial layer (25)

3. The device of claim 1, wherein the circuit (5) comprises a CMOS device including a NMOS transistor (31) formed in the epitaxial layer (25) and a PMOS transistor (39) formed in a second well region (33) of the first conductivity type formed in the epitaxial layer (25).

4. The device of claim 1, wherein an impurity concentration of the drain diffused region (7) is higher than that of the epitaxial layer (25).

5. The device of claim 1, further including:

   a buried region (40) of the second conductivity type, provided on the bottom of the epitaxial layer (25) and having a higher impurity concentration than that of the epitaxial layer (25).

6. The device of claim 1, further including:

   a first buried region (40) of the second conductivity type, formed between the epitaxial layer (25) and the substrate (1) the buried region (40) having a higher impurity concentration than that of the epitaxial layer (25); and

   a second buried region (81) of the first conductivity type, formed between the drain diffused region (7) and the substrate (1) in contact with the channel region (9) to form a Zener diode in the vertical MOS transistor (3).

7. The device of claim 6, wherein said source electrode (19) is electrically in contact with said channel region (9) through a well contact region (13).

8. The device of claims 1 and 5, wherein said source electrode (19) is electrically in contact with the channel region (9) through a well contact region (13).

9. The device of claim 8, further comprising an intermediate region (81) in contact with and between the substrate (1) and the well region (9), the impurity concentration being chosen higher than that of the drain diffused region (7).

10. The device of claim 5, wherein the circuit (5) comprises a CMOS device including a NMOS transistor (31) formed in the epitaxial layer (25) and a PMOS transistor (39) formed in a second well region (33) of the first conductivity type formed in the epitaxial layer (25).

11. The device of claim 6, wherein the circuit (5) comprises a CMOS device including a NMOS transistor (31) formed in the epitaxial layer (25) and a PMOS transistor (39) formed in a second well region (33) of the first conductivity type formed in the epitaxial layer (25).

**Revendications**

1. Dispositif semiconducteur comprenant :
   un substrat (1) d'un premier type de conductivité ,
   une couche épitaxiale (25) d'un second type de conductivité opposé au premier type de conductivité ;
   une zone diffusée de drain (7) du premier type de conductivité s'étendant de la surface de la couche épitaxiale (25) jusqu'à une profondeur à laquelle elle est en contact avec le substrat(1) ;
   une zone de canal (9) du second type de conductivité formée dans la partie supérieure de ladite zone diffusée de drain (7) et formant une première zone de puits ;
   des zones de source (11) du premier type de conductivité formées à l'intérieur de ladite zone de canal (9) ;
   une électrode de grille (15) formée sur la zone de canal (9) via un film d'oxyde de grille (17) formé entre elles ;
   une électrode de source (19) en contact avec les zones de source (11) ;
   une électrode de drain (18) en contact avec le substrat (1) ;
   lesdites trois zones, trois électrodes et ledit substrat constituant de façon combinée un transistor vertical MOS (3) ; et
   un circuit (5) fabriqué sur la couche épitaxiale (25) qui est isolé électriquement du transistor vertical MOS (3) pendant un fonctionnement par une polarisation inverse entre le substrat (1) et la couche épitaxiale (25).

2. Dispositif selon la revendication 1, dans lequel le circuit (5) comprend un dispositif CMOS incluant une zone enterrée (40) du second type de conductivité, formée entre la couche épitaxiale (25) et le substrat (1), la zone enterrée (40) ayant une concentration en impureté plus élevée que celle de la couche épitaxiale (25).

3. Dispositif selon la revendication 1, dans lequel le circuit (5) comprend un dispositif CMOS incluant un transistor NMOS (31) formé dans la couche épitaxiale (25) et un transistor PMOS (39) formé dans une seconde zone de puits (33) du premier type de conductivité formée dans la couche épitaxiale (25).

4. Dispositif selon la revendication 1, dans lequel une concentration en impureté de la zone diffusée de drain (7) est supérieure à celle de la couche épitaxiale (25).

5. Dispositif selon la revendication 1, incluant de plus :
   une zone enterrée (40) du second type de conductivité, prévue sur le fond de la couche épitaxiale (25) et ayant une concentration en impureté supérieure à celle de la couche épitaxiale (25).

6. Dispositif selon la revendication 1, incluant de plus :
   une première zone enterrée (40) du second type de conductivité, formée entre la couche épitaxiale (25) et le substrat (1), la zone enterrée (40) ayant une concentration en impureté supérieure à celle de la couche épitaxiale (25) ; et
   une seconde zone enterrée (81) du premier type de conductivité, formée entre la zone diffusée de drain (7) et le substrat (1) en contact avec la zone de canal (9) pour former une diode Zener dans le transistor vertical MOS (3).

7. Dispositif selon la revendication 6, dans lequel ladite électrode source (19) est en contact électrique avec ladite zone de canal (9) à travers une zone de contact de puits (13).

8. Dispositif selon les revendications 1 et 5, dans lequel ladite électrode source (19) est en contact électrique avec la zone de canal (9) à travers une zone de contact de puits (13).

9. Dispositif selon la revendication 8, comprenant en outre une région intermédiaire (81) située en contact avec et entre le substrat (1) et la zone de puits (9), la concentration en impureté étant choisie supérieure à celle de la zone diffusée de drain (7).

10. Dispositif selon la revendication 5, dans lequel le circuit (5) comprend un dispositif CMOS incluant un transistor NMOS (31) formé dans la couche épitaxiale (25) et un transistor PMOS (39) formé dans une seconde zone de puits (33) du premier type de conductivité formée dans la couche épitaxiale (25).

11. Dispositif selon la revendication 6, dans lequel le circuit (5) comprend un dispositif CMOS incluant un transistor NMOS (31) formé dans la couche épitaxiale (25) et un transistor PMOS (39) formé dans une seconde zone de puits (33) du premier type de conductivité formée dans la couche épitaxiale (25).

**Patentansprüche**

1. Halbleitervorrichtung, mit:

einem Substrat (1) von einem ersten Leitfähigkeitstyp;

einer Epitaxialschicht (25) eines zweiten, entgegengesetzten Leitfähigkeitstyps zu dem ersten Leitfähigkeitstyp;

einer Drain-Diffusionszone (7) von dem ersten Leitfähigkeitstyp, welche sich von der Oberfläche der Epitaxialschicht (25) bis zu einer Tiefe erstreckt, in welcher sie in Kontakt mit dem Substrat (1) ist;

eine Kanalzone (9) von dem zweiten Leitfähigkeitstyp, welche in dem oberen Teil der Drain-Diffusionszone (7) gebildet ist, und einen ersten Wannenbereich bildet;

einer Source-Zone (11) von dem ersten Leitfähigkeitstyp, welche innerhalb der Kanalzone (9) gebildet ist;

einer Gate-Elektrode (15), die auf der Kanalzone (9) über einem dazwischen gebildeten Gate-Oxyd-Film (17) gebildet ist;

einer Source-Elektrode (19) im Kontakt mit der Source-Zone (11);

einer Drain-Elektrode (18) im Kontakt mit dem Substrat (1);

wobei die drei Zonen, die drei Elektroden und das Substrat gemeinsam einen vertikalen MOS-Transistor (3) bilden; und

mit einem auf der Epitaxialschicht (25) hergestellten Schaltkreis (5), welcher von dem vertikalen MOS-Transistor (3) während der Wirkung einer umgekehrten Spannung zwischen dem Substrat (1) und der Epitaxialschicht (25) elektrisch isoliert ist.

2. Die Vorrichtung nach Anspruch 1, wobei der Schaltkreis (5) eine CMOS-Einrichtung, welche einen begrabenen Bereich (40) von dem zweiten Leitfähigkeitstyp enthält, der zwischen der Epitaxialschicht (25) und dem Substrat (1) gebildet ist, wobei der begrabene Bereich (40) eine höhere Verunreinigungskonzentration als die Epitaxialschicht (25) aufweist.

3. Die Vorrichtung nach Anspruch 1, wobei der Schaltkreis (5) eine CMOS-Einrichtung umfaßt, welche einen NMOS-Transistor (31), der in der Epitaxialschicht (25) gebildet ist, und einen PMOS-Transistor (39), der in einem zweiten in der Epitaxialschicht (25) gebildeten Wannenbereich (33) vom ersten Leitfähigkeitstyp gebildet ist, enthält.

4. Die Vorrichtung nach Anspruch 1, wobei eine Verunreinigungskonzentration der Drain-Diffusionszone (7) höher als diejenige der Epitaxialschicht (25) ist.

5. Die Vorrichtung nach Anspruch 1, welche ferner umfaßt: einen begrabenen Bereich (40) von dem zweiten Leitfähigkeitstyp, welcher auf dem Boden der Epitaxialschicht (25) vorgesehen ist und eine höhere Verunreinigungskonzentration als die Epitaxialschicht (25) aufweist.

6. Die Vorrichtung nach Anspruch 1, welche ferner umfaßt:

einen ersten begrabenen Bereich (40) von dem zweiten Leitfähigkeitstyp, welcher zwischen der Epitaxialschicht (25) und dem Substrat (1) gebildet ist, wobei der begrabene Bereich (40) eine höhere Verunreinigungskonstration als die Epitaxialschicht (25) aufweist; und

einen zweiten begrabenen Bereich (81) von dem ersten Leitfähigkeitstyp, welcher zwischen der Drain-Diffusionszone (7) und dem Substrat (1) im Kontakt mit der Kanalzone (9) gebildet ist, um eine Zenerdiode in dem vertikalen MOS-Transistor (3) zu bilden.

7. Die Vorrichtung nach Anspruch 6, wobei die Source-Elektrode (19) elektrisch über einen Wannenkontaktbereich (13) im Kontakt mit der Kanalzone (9) ist.

8. Die Vorrichtung nach Anspruch 1 und 5, wobei die Source-Elektrode (19) elektrisch über einen Wannenkontaktbereich (13) im Kontakt mit der Kanalzone (9) ist.

9. Die Vorrichtung nach Anspruch 8, welche ferner einen Zwischenbereich (81) im Kontakt mit und zwischen dem Substrat (1) und dem Wannenbereich (9) umfaßt, wobei die Verunreinigungskonzentration höher als diejenige der Drain-Diffusionszone (7) gewählt ist.

10. Die Vorrichtung nach Anspruch 5, wobei der Schaltkreis (5) eine CMOS-Einrichtung umfaßt, welche einen NMOS-Transistor (31), der in der epitaxialen Schicht (25) gebildet ist, und einen PMOS-Transistor (39), welcher in einem zweiten, in der Epitaxialschicht (25) gebildeten Wannenbereich (33) von dem ersten Leitfähigkeitstyp gebildet ist, enthält.

11. Die Vorrichtung nach Anspruch 6, wobei der Schaltkreis (5) eine CMOS-Einrichtung umfaßt, welche einen NMOS-Transistor (31), der in der Epitaxialschicht (25) gebildet ist, und einen PMOS-Transistor (39), der in einem zweiten, in der Epitaxialschicht (25) gebildeten Wannenbereich (33) von dem ersten Leitfähigkeitstyp gebildet ist, enthält.

FIG. 1

# FIG. 2

EP 0 193 172 B1

EP 0 193 172 B1

## FIG. 3

## FIG. 4

EP 0 193 172 B1

FIG.5(A)

65

1

FIG.5(B)

40

25

1

FIG.5(C)

67        67

40

25

1

FIG.5(D)

7        33

25

40

1

FIG.5(E)

15    15    17        42        46

7            33

25

40

1

FIG.5(F)

15    15        42    46    69

7        33    17

25

40

1

13

FIG.5 (G)

FIG.5 (H)

FIG.5 (I)

FIG.5 (J)

FIG.5 (K)

14

# FIG. 6

EP 0 193 172 B1

# FIG. 7

EP 0 193 172 B1